# EUROPEAN PATENT APPLICATION

(11) **EP 3 070 746 A1**
(43) Date of publication of application: **21.09.2016**
(21) Application number: 15866397.1
(22) Date of filing: 10.11.2015
(51) Int. Cl.: H01L 29/786, H01L 21/28

(54) **ARRAY SUBSTRATE, MANUFACTURING METHOD THEREOF AND DISPLAY DEVICE**

(30) Priority: 22.12.2014 CN 201410806984
(71) Applicant: BOE Technology Group Co., Ltd., Beijing 100015 (CN)
(72) Inventor: SHI, Lei, Beijing 100176 (CN); XU, Xiaowei, Beijing 100176 (CN)
(74) Representative: Potter Clarkson LLP
(86) International application number: PCT/CN2015/094175
(87) International publication number: WO 2016/101719

(57) **Abstract**

Embodiments of the present disclosure provide an array substrate, a method for producing the same and a display device including the same. The array substrate includes a substrate; a first gate, a first gate insulation layer, an active layer, a second gate insulation layer, a second gate, a third gate insulation layer and source and drain electrodes provided on the substrate in sequence. Two side regions outside a region of the active layer corresponding to the second gate are source and drain-lightly doped regions and source and drain-heavily doped regions, respectively. The source and drain electrodes are contacted and connected with the heavily doped source and drain regions, respectively. The first gate is provided below the lightly doped drain region corresponding to the drain electrode, or the first gate includes a first sub part and a second sub part which are respectively provided below the lightly doped source and drain regions corresponding to the source and drain electrodes respectively.

## Description

### CROSS-REFERENCE TO RELATED APPLICATION

This application claims the benefit of Chinese Patent Application No. 201410806984.2 filed on December 22, 2014 and entitled as "Display device, Array Substrate and Method for Producing The Same" in the State Intellectual Property Office of China, the whole disclosure of which is incorporated herein by reference.

### BACKGROUND OF THE INVENTION

### Field of the Invention

The present disclosure relates to the technical field of display process, and particularly, to an array substrate, a method for producing the same and a display device including the array substrate.

### Description of the Related Art

In Liquid Crystal Displays (LCDs) or Organic Light-Emitting Displays (OLEDs), each pixel point is driven by a Thin Film Transistor (TFT) integrated behind the pixel point, thereby displaying screen information with high speed, high brightness and high contrast. In the prior art, it is often to manufacture the TFT by poly-silicon or amorphous silicon. Carriers of the poly-silicon have a mobility of 10-200 cm²/V, which is apparently higher than that (1cm²/V) of the carriers of the amorphous silicon, and thus in contrast to the amorphous silicon, the poly-silicon has higher capacitance and storage capability.

The TFTs of the LCD or OLED are usually formed onto a glass substrate. Due to thermodynamic limitation of the glass, crystalline characteristics of the poly-silicon TFT cannot be effectively recovered by annealing after ion implantation. A relatively large leakage current occurring in the presence of a reversed bias voltage, will affect normal use of the TFT.

In order to suppress the leakage current of the TFT, it is common to perform a light doping between a gate electrode of the TFT and source and drain electrodes thereof. Especially in a case of some short channels, a lightly doped drain (LDD) region has a width range of only 0.3-1µm. Due to the provision of the LDD region, when the TFT is in a normal operation, ON-state current is often affected, which causes the TFT in the normal operation to have too large resistance and cause increasing of a power dissipation thereof.

### SUMMARY

In view of this, embodiments of the present disclosure are intended to provide an array substrate, a method for producing the same and a display device including the same, so as to overcome the defect present in the art that when the TFT is working, an ON-state current is reduced due to the presence of the LDD structure provided for reducing the TFT's Off-state current.

In accordance with an aspect of the present disclosure, it provides an array substrate, comprising:
a substrate;
a first gate and a first gate insulation layer provided on the substrate in sequence;
an active layer provided on the first gate insulation layer;
a second gate insulation layer, a second gate, a third gate insulation layer and source and drain electrodes, provided on the active layer in sequence, wherein the source and drain electrodes are provided on the third gate insulation layer;
wherein two side regions outside a region of the active layer corresponding to the second gate are lightly doped source and drain regions, and heavily doped source and drain regions, respectively, wherein the lightly doped source region and the lightly doped drain region are immediately adjacent to the second gate, the heavily doped source region is immediately adjacent to the lightly doped source region, the heavily doped drain region is immediately adjacent to the lightly doped drain region, and the source and drain electrodes are electrically connected with the heavily doped source and drain regions, respectively;
wherein the first gate is provided below the lightly doped drain region corresponding to the drain electrode, or the first gate includes a first sub part of the first gate and a second sub part of the first gate, which are provided below the lightly doped source region and lightly doped drain region respectively corresponding to the source and drain electrodes, respectively.

Preferably, the active layer is an active layer in a polycrystalline state formed by crystallizing an amorphous oxide.

Preferably, the active layer is low temperature poly-silicon.

Preferably, the third gate insulation layer and the second gate insulation layer are provided with via holes, through which the source and drain electrodes are contacted and connected with the heavily doped source and drain regions, respectively.

Preferably, a buffer layer is provided between the substrate and the first gate.

In accordance with another aspect of the present disclosure, it also provides a display device, comprising the array substrate as described above.

In accordance with a further aspect of the present disclosure, it also provides a method for producing an array substrate, comprising:
forming a pattern of a first gate on a substrate;
forming a first gate insulation layer on the substrate subjected to the preceding step;
forming an active layer on the substrate subjected to the preceding steps;
forming a second gate insulation layer on the substrate subjected to the preceding steps;
forming a pattern of a second gate on the substrate subjected to the preceding steps;
performing source and drain-heavily doping and source and drain-lightly doping on two side regions outside a region of the active layer corresponding to the second gate, wherein the lightly doped source region and the lightly doped drain region are immediately adjacent to the active layer corresponding to the second gate, the heavily doped source region is immediately adjacent to the lightly doped source region, and the heavily doped drain region is immediately adjacent to the lightly doped drain region;
forming a third gate insulation layer on the substrate subjected to the preceding steps, and forming via holes thereon;
forming a pattern of source and drain electrodes on the substrate subjected to the preceding steps, wherein the source ad drain electrodes are electrically connected with the heavily doped source and drain regions through the via holes, respectively;
wherein the first gate is provided below the lightly doped drain region corresponding to the drain electrode, or the first gate includes a first sub part of the first gate and a second sub part of the first gate, which are provided below the lightly doped source region and lightly doped drain region respectively corresponding to the source and drain electrodes, respectively.

Preferably, the active layer is an active layer in a polycrystalline state formed by crystallizing an amorphous oxide.

Preferably, the active layer is low temperature poly-silicon, and the crystallizing process is an excimer laser annealing.

Preferably, the step of performing source and drain-heavily doping and source and drain lightly doping on two side regions outside a region of the active layer corresponding to the second gate comprises the steps of :
retaining a photo resist after the etching for the second gate, wherein there is a deviation in critical dimension between the photo resist and the second gate, and the region of the active layer which is not shielded by the photo resist is heavily doped;
peeling off the photo resist and lightly doping the region of the active layer which is not shielded by the second gate.

The array substrate of the present disclosure is provided with the first gate 3 (bottom gate) and the second gate 7 (top gate) and employs the LDD structure. On one hand, in combination with a working principle of the bottom gate structure, when the TFT is working (i.e., the top gate is applied with a gate voltage), the bottom gate is also switched on to cause the LDD region to induce carriers; in this way, the LDD region under the action of an electric field of the bottom gate and with the carriers being generated at the lightly doped regions can avoid the disadvantageous effect of reducing the On-state current Iₒₙ caused by the lightly doping. On the other hand, when the electric field of the top gate of the TFT is removed, the bottom gate is switched off, and meanwhile the electric field of the bottom gate is also removed, thereby reducing the Off-state leakage current of the TFT. That is, the advantage that the LDD structure can reduce the Off-state leakage current I_{off} is utilized.

### BRIEF DESCRIPTION OF THE DRAWINGS

Figs. 1-6 are schematic views for showing respective structures corresponding to respective manufacturing steps of an array substrate in accordance with an embodiment of the present disclosure;
Fig. 7 is a schematic view for showing a structure of an array substrate in accordance with another embodiment of the present disclosure;
Fig. 8 is a flow chart of a method for producing an array substrate in accordance with an embodiment of the present disclosure.

### DETAILED DESCRIPTION OF THE EMBODIMENTS

The specific embodiments of the present disclosure are described in detail in conjunction with the drawings and examples thereof. The following embodiments are intended to explain the present disclosure, rather than limiting the scope of the present disclosure.

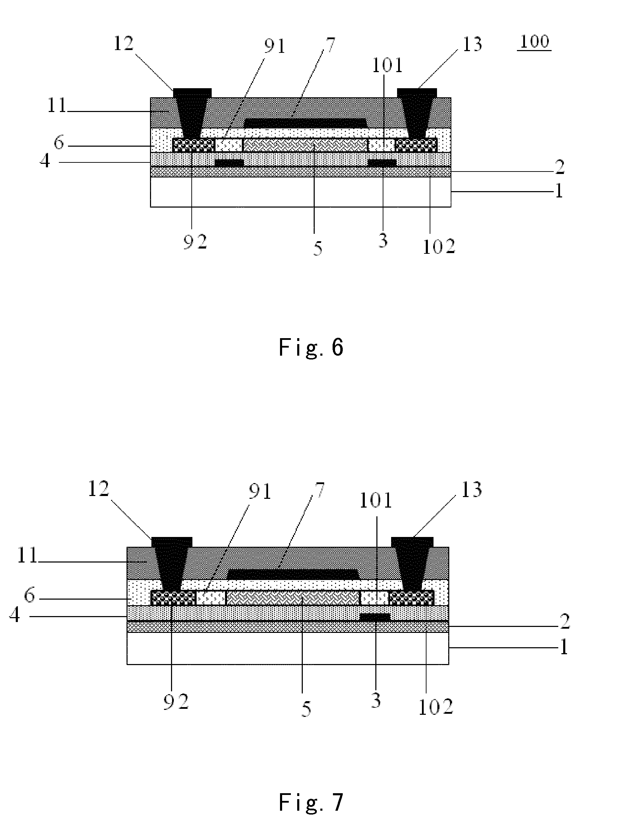

As shown in Fig. 6, an array substrate 100 provided in accordance with one or more of embodiments of the present disclosure includes a substrate 1, a buffer layer 2 (optionally) provided onto the substrate 1, a first gate (i.e., a bottom gate) 3 and a first gate insulation layer 4. An active layer 5 is provided onto the first gate insulation layer 4, and a second gate insulation layer 6, a second gate (i.e., a top gate) 7, a third gate insulation layer 11, a source electrode 12 and a drain electrode 13 are arranged on the active layer 5 in sequence, and the source electrode 12 and the drain electrode 13 are located on the third gate insulation layer 11. Two side regions of the active layer 5 outside a region thereof which corresponds to the second gate 7 are lightly doped source and drain regions 91, 101 and heavily doped source and drain regions 92, 102, wherein the lightly doped source and drain regions 91 and 101 are immediately adjacent to the region of the active layer 5 corresponding to the second gate 7 and located at two sides of the region respectively, and the heavily doped source region 92 is immediately adjacent to the lightly doped source region 91 and the heavily doped drain region 102 is immediately adjacent to the lightly doped drain region 101. The source and drain electrodes 12 and 13 are electrically connected with the heavily doped source and drain regions 92 and 102, respectively.

It should be noted that the first gate 3 may include two parts, i.e., a first sub part 31 thereof and a second sub part 32 thereof, disposed below the lightly doped source and drain regions corresponding to the source and drain electrodes 12 and 13 respectively, that is, disposed below the lightly doped source region 91 and the lightly doped drain region 101 respectively.

The array substrate of the present embodiment is provided with the first gate 3 (bottom gate) and the second gate 7 (top gate) and adopts the LDD structure. On one hand, in combination with a working principle of the bottom gate structure, when the TFT is working (i.e., the top gate is applied with a gate voltage), the bottom gate is also switched on to cause the LDD region to induce carriers; in this way, the LDD region under the action of an electric field of the bottom gate and with the carriers being generated at the lightly doped regions can avoid the disadvantageous effect of reducing the On-state current Iₒₙ caused by the lightly doping. On the other hand, when the electric field of the top gate of the TFT is removed, the bottom gate is switched off, and meanwhile the electric field of the bottom gate is also removed, thereby reducing the Off-state leakage current of the TFT. That is, the benefit that the LDD structure can reduce the Off-state leakage current I_{off} is utilized.

In an embodiment, the active layer 5 is an active layer in a polycrystalline state which is formed by crystallizing an amorphous oxide. Specifically, the active layer 5 is low temperature poly-silicon.

In an embodiment, the third gate insulation layer 11 and the second gate insulation layer 6 are provided with via holes 16 and 17 thereon, respectively, and the source electrode 12 and the drain electrode 13 are contacted and connected with the heavily doped source and drain regions 92, 102 by the via holes 16 and 17, respectively. The heavily doped source and drain regions 92, 102 are located at the outside of the lightly doped source and drain regions 91, 101 respectively, far away from the active layer 5.

In the array substrate provided by the present disclosure, the LDD structure can reduce the TFT's Off-state leakage current, and meanwhile the bottom gate arrangement can increase the TFT's On-state current, thereby improving the yield of the corresponding product.

As shown in Fig. 7, it is a schematic view for showing a structure of an array substrate in accordance with another embodiment of the present disclosure. In the present embodiment, the first gate 3 is formed of a single part, which is provided below the lightly doped drain region 101 corresponding to the drain electrode 13.

As such, in the array substrate of the present embodiment, both the first gate 3 and the second gate 7 are provided, and the advantage of reducing the Off-state current by means of the LDD is obtained. On one hand, in combination with the working principle of the bottom gate structure, when the TFT is working (i.e., the top gate is applied with a gate voltage), the bottom gate is switched on to cause the LDD region to induce carriers; in this way, the LDD region under the action of an electric field of the bottom gate and with the carriers being generated at the lightly doped regions can avoid the disadvantageous effect of reducing the On-state current Iₒₙ caused by the lightly doping. On the other hand, when the electric field of the top gate of the TFT is removed, the bottom gate is switched off, and meanwhile the electric field of the bottom gate is also removed, thereby reducing the Off-state leakage current of the TFT. That is, the advantage that the LDD structure can reduce the Off-state leakage current I_{off} is utilized.

Furthermore, one or more of the embodiments of the present disclosure also provides a display device, including the array substrate as described in any of the preceding embodiments. The array substrate includes, but not limits to, the devices such as liquid crystal displays, liquid crystal TVs or liquid crystal display screens, and the devices may also be display devices which need display modules such as digital photo frames, E-papers, mobile phones and the like.

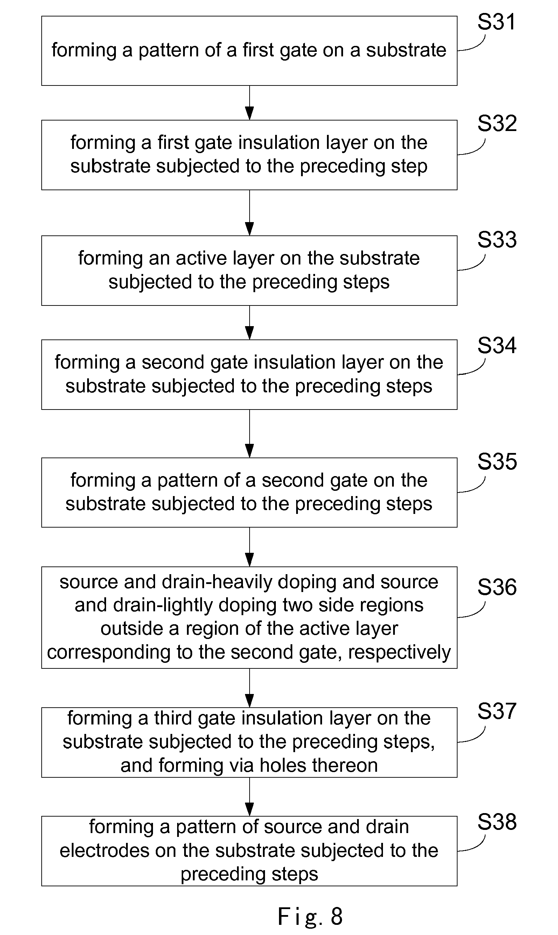

Below with reference to Fig. 8, a method for producing the array substrate in accordance with one or more of the embodiments of the present disclosure is described, including the following steps of:
Step S31, forming a pattern of the first gate on the substrate; optionally, firstly forming a buffer layer on the substrate and then forming the pattern of the first gate on the substrate; according to practical requirements, it is possible to form a first gate structure including a first sub part of the first gate and a second sub part of the first gate on the substrate or the buffer layer, or form a first gate structure including only one part;
Step S32, forming a first gate insulation layer on the substrate the step S31;
Step S33, forming an active layer on the substrate after the step S32;
Step S34, forming a second gate insulation layer on the substrate after the step S33;
Step S35, forming a pattern of a second gate on the substrate after the step S34;
Step S36, source and drain-heavily doping and source and drain-lightly doping two side regions outside a region of the active layer corresponding to the second gate, wherein the lightly doped source region and the lightly doped drain region are immediately adjacent to the region of the active layer corresponding to the second gate and located at two sides of the region respectively; and the heavily doped source region is immediately adjacent to the lightly doped source region and the heavily doped drain region is immediately adjacent to the lightly doped drain region;
Step 37, forming a third gate insulation layer on the substrate after the step S36 and forming via holes on the third gate insulation layer;
Step S38, forming patterns of source and drain electrodes on the substrate after the step S37, wherein the source and drain electrodes are electrically connected with the heavily doped source and drain regions through the via holes, wherein the first gate is disposed below the lightly doped drain region corresponding to the drain electrode.

In a further embodiment, when the first gate is consisted of two parts, that is, when it includes a first sub part 31 of the first gate and a second sub part 32 of the first gate, the two sub parts of the first gate are provided below the lightly doped source and drain regions corresponding to the source and drain electrodes, respectively.

In an embodiment, the active layer is an active layer in a polycrystalline state which is formed by crystallizing an amorphous oxide. Specifically, the active layer is low temperature poly-silicon. The crystallizing process is an excimer laser annealing, thereby facilitating an attachment between respective films or layers.

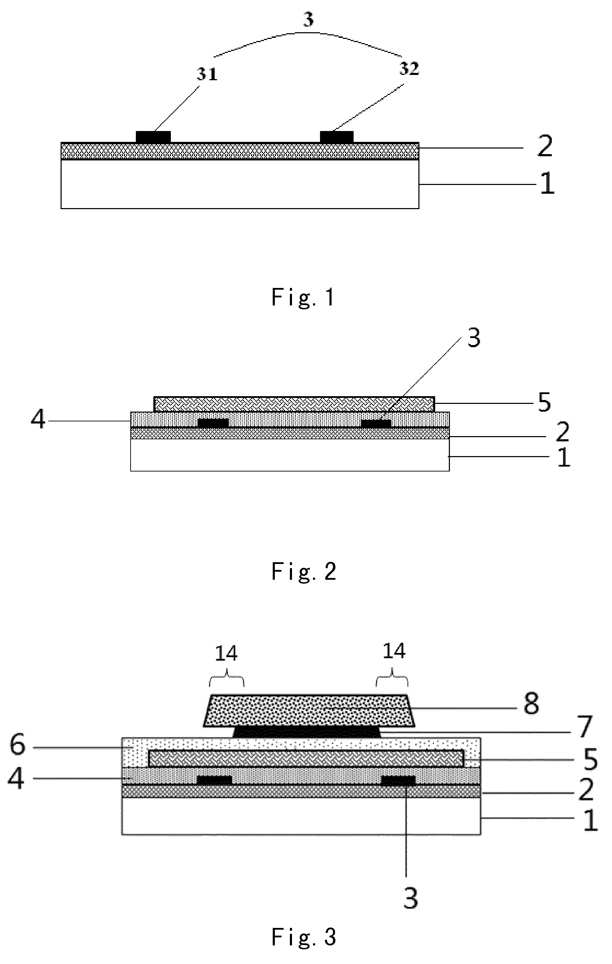

In an embodiment, for example as shown in Fig. 3, the step S36 of source and drain-heavily doping and source and drain-lightly doping two side regions outside a region of the active layer corresponding to the second gate specifically includes:
retaining a photo resist 8 after the etching for the second gate, wherein there is a deviation in critical dimension (CD) between the photo resist 8 and the second gate 7, and the region of the active layer which is not shielded or protected by the photo resist 8 is heavily doped;
peeling off the photo resist 8 and lightly doping the region of the active layer which is not shield or protected by the second gate 7.

In the method for producing the array substrate provided by the present disclosure, the LDD arrangement can reduce the TFT's Off-state leakage current, and meanwhile the bottom gate arrangement can increase the TFT's On-state current, thereby improving the yield of the corresponding product.

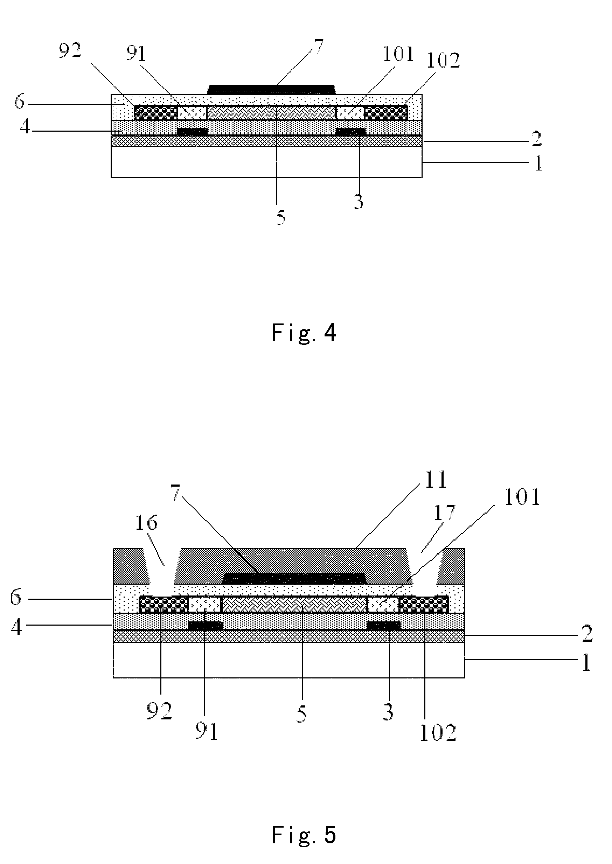

One specific example of the method for producing the array substrate in accordance with one or more of the embodiments of the present disclosure is described in detail with reference to Figs. 1-6, including the following steps of:
Step S 1: depositing a buffer layer 2 on a glass substrate 1 by plasma enhanced chemical vapor deposition (PECVD), wherein a material for the buffer layer 2 is selected from SiNx, SiOx or a mixture thereof.
Step S2: forming a first gate 3 (i.e., a bottom gate) by a sputtering method on the substrate subjected to the step S1, and forming a pattern of the bottom gate by a lithographic process and an etching process, as shown in Fig. 1. In this example, the first gate 3 is consisted of two parts, located below the lightly doped regions corresponding to the source and drain electrodes subsequently to be formed, respectively.
Step S3: forming a first gate insulation layer 4 by PECVD, forming an active layer 5 by PECVD and translating the amorphous active layer into an polycrystalline state by an crystallizing process such as an excimer laser annealing (ELA) technique, as shown in Fig. 2.
Step S4: forming a second gate insulation layer 6 by PECVD on the substrate subjected to the step S3, forming a second gate 7 (i.e., a top gate) by a sputtering process, and forming a pattern of the top gate by a lithographic process and an etching process; furthermore, a process of removing the photo resist 8 is not performed after wet-etching the top gate structure, and instead the photo resist 8 is retained, wherein there is a deviation in critical dimension (CD) between the photo resist 8 and the second gate 7, as shown in Fig. 3.
Step S5: on the substrate subjected to the step S4, source and drain-heavily doping a region of the active layer which is not shielded by the photo resist 8 to form the heavily doped source and drain regions 92 and 102, so as to achieve a good contact with metal electrodes; then, removing the photo resist 8 and lightly doping a region of the active layer which is not shielded by the second gate 7 so as to form a LLD structure, wherein the heavily doped source and drain regions will not be affected by the lightly doping, as shown in Fig. 4. Specifically, the lightly doped source region 91 and the lightly doped drain region 101 are immediately adjacent to the second gate 7; and the heavily doped source region 92 is immediately adjacent to the lightly doped source region 91 and the heavily doped drain region 102 is immediately adjacent to the lightly doped drain region 101.

It should be noted that heavily doping and lightly doping in this step can be done by existing processes. An improvement of the present disclosure lies in a positional relationship between the heavily doping source and drain regions and the lightly doping source and drain regions, rather than the doping processes themselves.

Step S6: on the basis of the substrate subjected to the above steps, forming a third gate insulation layer 11 by PECVD, performing a lithographic process and an etching process to form via holes 16 and 17 for the source and drain metal electrodes, as shown in Fig. 5.

Step S7: on the basis of the substrate subjected to the above steps, depositing a metal film of source and drain electrodes or forming a source and drain metal electrode layer by a sputtering process, and forming a pattern of the source electrode 12 and the drain electrode 13 by a lithographic process and an etching process, as shown in Fig. 6.

The above embodiments are only preferred embodiments of the present disclosure, and it should be noted that various modifications and changes may be made to the present disclosure by those skilled in the art without departing from the principles and spirit of the present disclosure. As such, these modifications and changes to the present disclosure are also intended to be included within the present disclosure if they fall within the scopes of the present disclosure defined by claims and equivalents thereof.

## Claims

1. An array substrate, comprising:
a substrate;
a first gate and a first gate insulation layer provided on the substrate in sequence;
an active layer provided on the first gate insulation layer;
a second gate insulation layer, a second gate, a third gate insulation layer and source and drain electrodes, which are provided on the active layer in sequence, wherein the source and drain electrodes are provided on the third gate insulation layer;
wherein two side regions outside a region of the active layer corresponding to the second gate are lightly doped source and drain regions and heavily doped source and drain regions respectively, wherein the lightly doped source region and the lightly doped drain region are immediately adjacent to the second gate, the heavily doped source region is immediately adjacent to the lightly doped source region, the heavily doped drain region is immediately adjacent to the lightly doped drain region, and the source and drain electrodes are electrically connected with the heavily doped source and drain regions, respectively;
wherein the first gate is provided below the lightly doped drain region corresponding to the drain electrode, or the first gate includes a first sub part of the first gate and a second sub part of the first gate, which are respectively provided below the lightly doped source region and the lightly doped drain region corresponding to the source and drain electrodes respectively.

2. The array substrate as claimed in claim 1, wherein the active layer is an active layer in a polycrystalline state formed by crystallizing an amorphous oxide.

3. The array substrate as claimed in claim 2, wherein the active layer is made of low temperature poly-silicon.

4. The array substrate as claimed in claim 1, wherein the third gate insulation layer and the second gate insulation layer are provided with via holes, through which the source and drain electrodes are contacted and connected with the heavily doped source and drain regions, respectively.

5. The array substrate as claimed in claim 1, wherein a buffer layer is provided between the substrate and the first gate.

6. A display device, comprising the array substrate as claimed in any of claims 1-5.

7. A method for producing an array substrate, comprising:
forming a pattern of a first gate on a substrate;
forming a first gate insulation layer on the substrate subjected to the preceding step;
forming an active layer on the substrate subjected to the preceding steps;
forming a second gate insulation layer on the substrate subjected to the preceding steps;
forming a pattern of a second gate on the substrate subjected to the preceding steps;
source and drain-heavily doping and source and drain-lightly doping two side regions outside a region of the active layer corresponding to the second gate respectively, wherein the lightly doped source region and the lightly doped drain region are immediately adjacent to the active layer corresponding to the second gate, the heavily doped source region is immediately adjacent to the lightly doped source region, and the heavily doped drain region is immediately adjacent to the lightly doped drain region;
forming a third gate insulation layer on the substrate subjected to the preceding steps, and forming via holes thereon;
forming a pattern of source and drain electrodes on the substrate subjected to the preceding steps, wherein the source and drain electrodes are electrically connected with the heavily doped source and drain regions through the via holes, respectively;
wherein the first gate is provided below the lightly doped drain region corresponding to the drain electrode, or the first gate includes a first sub part of the first gate and a second sub part of the first gate, which are respectively provided below the lightly doped source region and the lightly doped drain region corresponding to the source and drain electrodes respectively.

8. The method as claimed in claim 7, wherein the active layer is an active layer in a polycrystalline state formed by crystallizing an amorphous oxide.

9. The method as claimed in claim 8, wherein the active layer is made of low temperature poly-silicon, and the crystallizing process is an excimer laser annealing.

10. The method as claimed in claim 7, wherein the step of source and drain-heavily doping and source and drain-lightly doping two side regions outside a region of the active layer corresponding to the second gate comprises steps of :
retaining a photo resist after the etching for forming the second gate, wherein there is a deviation in critical dimension between the photo resist and the second gate, and heavily doping a region of the active layer which is not shielded by the photo resist;
peeling off the photo resist and lightly doping a region of the active layer which is not shielded by the second gate.
